# EUROPÄISCHE PATENTSCHRIFT

(11) **EP 2 758 991 B1**
(45) Veröffentlichungstag und Bekanntmachung des Hinweises auf die Patenterteilung: **12.11.2014**
(21) Anmeldenummer: 11761574.0
(22) Anmeldetag: 22.09.2011
(51) Int. Cl.: H01L 21/67

(54) **VORRICHTUNG UND VERFAHREN ZUR BEHANDLUNG VON SUBSTRATOBERFLÄCHEN**
DEVICE AND METHOD FOR TREATING SUBSTRATE SURFACES
DISPOSITIF ET PROCEDE DE TRAITEMENT DE SURFACES DE SUBSTRATS

(43) Veröffentlichungstag der Anmeldung: 30.07.2014
(73) Patentinhaber: Ev Group E. Thallner GmbH, 4782 St. Florian am Inn (AT)
(72) Erfinder: GLINSNER, Thomas, A-4782 St. Florian am Inn (AT); HOLZLEITNER, Ronald, A-4644 Scharnstein (AT); WIESER, Thomas, 84375 Kirchdorf am Inn (DE); SCHMID, Florian, 4941 Mehrnbach (AT)
(74) Vertreter: Schweiger, Johannes
(86) Internationale Anmeldenummer: PCT/EP2011/066529
(87) Internationale Veröffentlichungsnummer: WO 2013/041144

(56) Entgegenhaltungen:
- EP-A1- 1 811 552
- WO-A1-2007/128659
- JP-A- 10 209 023
- US-A- 5 769 945
- US-A- 5 916 366
- US-A1- 2004 250 839

## Beschreibung

Die vorliegende Erfindung betrifft eine Vorrichtung zur Behandlung einer Substratbehandlungsfläche eines Substrats, insbesondere Wafers, mit einem Fluid, insbesondere einer Flüssigkeit, durch Eintauchen der Substratbehandlungsfläche in das Fluid gemäß Patentanspruch 1 sowie ein korrespondierendes Verfahren gemäß Patentanspruch 10.

Die Reinigung von Waferoberflächen spielt in der Halbleiterindustrie eine große Rolle, wobei eine Art der Reinigung von Waferoberflächen die nasschemische Behandlung ist, die auch für das Strippen von Polymeren verwendbar ist.

Eine für eine derartige Behandlung einer Waferoberfläche geeignete Vorrichtung ist etwa in WO 2007/128659 A1 gezeigt.

Meist findet die Reinigung der Waferoberflächen mittels Flüssigkeiten statt, die auf die Oberfläche des Substrats aufgebracht werden, insbesondere durch Flüssigkeitsstrudel, Tropfen, Schütten, Sprühen, Aufdampfen etc. Dabei wird häufig das Substrat rotiert oder das Substrat wird am Ende der Flüssigkeitsbeaufschlagung rotiert, um die Flüssigkeit von dem Substrat abzuschleudern.

Technische Probleme bestehen häufig dabei, dass die Wafer immer dünner werden, wodurch Beschädigungen beim Rotieren des Wafers und/oder bei der Aufbringung der Flüssigkeit auftreten können. Auch die gleichmäßige Beaufschlagung ist eine große Herausforderung, damit die gesamte Waferoberfläche mit den teils sehr teuren Flüssigkeiten zur Behandlung der Waferoberfläche gleichmäßig und effizient beaufschlagt wird. Weiterhin soll eine Verschwendung der Flüssigkeit vermieden werden.

Darüber hinaus ist es wünschenswert, dass der Reinigungsschritt innerhalb eines möglichst kurzen Zeitraums erfolgen kann.

Aufgabe der vorliegenden Erfindung ist es daher, eine möglichst effizient arbeitende Vorrichtung und ein korrespondierendes Verfahren zum Behandeln, insbesondere Reinigen, einer Substratbehandlungsfläche eines Substrats anzugeben, bei der eine gleichmäßige Behandlung mit geringst möglichem Flüssigkeitsverbrauch gewährleistet werden kann.

Diese Aufgabe wird mit den Merkmalen der Patentansprüche 1 und 10 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart gelten und in beliebiger Kombination beanspruchbar sein. Soweit zur Vorrichtung offenbarte Merkmale auch als Verfahrensmerkmale aufgefasst werden können, sollen diese auch als verfahrensgemäß offenbart gelten und umgekehrt.

Der Erfindung liegt der Gedanke zugrunde, die Substratbehandlungsfläche derart mit einem Fluid zu behandeln, dass das Substrat beziehungsweise die Substratbehandlungsfläche in eine in einem Behälter vorgesehene Flüssigkeit eingetaucht wird, insbesondere während einer Rotation der Substratbehandlungsfläche. Die Rotation kann auch in Intervallen erfolgen, während die Substratbehandlungsfläche in dem Fluid eingetaucht ist. Wesentliches Merkmal der Erfindung ist es dabei, dass der, insbesondere wannenförmige, Behälter rotierbar ist, damit nach einer oder mehrerer Behandlungen von Substratbehandlungsflächen das Fluid aus dem Behälter durch Rotation entfernt werden kann. Anschließend kann der Behälter mit einem frischen Fluid befüllt werden. Als Fluide kommen insbesondere Flüssigkeiten für die nasschemische Behandlung in Frage. Durch die erfindungsgemäße Ausgestaltung ist eine sehr homogene Beaufschlagung der Substratbehandlungsfläche und, insbesondere bei Rotation des Eintauchmittels, äußerst effiziente Einwirkung des Fluids auf die Substratbehandlungsfläche vorgesehen. Weiterhin gewährleistet die vorliegende Erfindung eine optimale Nutzung des Fluids sowie einen sehr einfachen Austausch des Fluids. Darüber hinaus findet während der Behandlung der Substratbehandlungsfläche eine geringstmögliche, insbesondere keine, Verwirbelung oder Versprühung des Fluids im Behandlungsraum statt, so dass eine sehr saubere Behandlung ermöglicht wird.

Sehr dünne Wafer können zur Fixierung auch auf sogenannten Film Frames befestigt werden. Erfindungsgemäß seien alle Arten von Wafern und Montierungen mit denen Wafer fixiert werden, sei es zur Stabilisierung und/oder zum Transport, offenbart. In der gesamten Patentschrift wird Wafer als Synonym für Einzelwafer oder für Wafer auf solchen Montierungen verwendet.

Gemäß einer vorteilhaften Ausführungsform der Erfindung ist vorgesehen, dass das Aufnahmemittel als, insbesondere rotationssymmetrische, Wanne, insbesondere mit einer in Radialrichtung angewinkelten Wannenwand, ausgebildet ist. Die Wannenform ist einfach herstellbar und bei rotationssymmetrischer Ausgestaltung auf einfache Weise rotierbar. Eine angewinkelte Wannenwand hat den Vorteil, dass der Austrag des Fluids erleichtert wird.

Hierbei ist es von Vorteil, wenn die Wanne gemäß einer weiteren vorteilhaften Ausführungsform einen entgegen der Wannenform gekrümmten, insbesondere die Rotationsmittel überkragenden Umfangsrand zur Ableitung des Fluids zu einem, insbesondere ringförmigen, Fluidsammelbecken aufweist. Auf diese Weise wird das Fluid gezielt in Richtung des Fluidsammelbeckens geführt, und zwar durch die Rotation der Wanne und das dadurch bewirkte Abfließen des Fluids über den gekrümmten Umfangsrand, wobei der Umfangsrand mit Vorteil in dem Fluidsammelbecken endet. Somit ist außerdem gewährleistet, dass das Fluid nicht mit anderen Bestandteilen außer der Substratbehandlungsfläche, dem Aufnahmemittel und dem Fluidsammelbecken in Berührung kommt. Weiterhin ist es erfindungsgemäß vorteilhaft, wenn das, insbesondere durch einen Stator gebildete, Fluidsammelbecken an seinem Boden, insbesondere in mindestens einem abgesenkten Bereich, vorzugsweise an der tiefsten Stelle des Fluidsammelbeckens, mindestens einen, insbesondere jeweils mit einem ansteuerbaren Ventil versehenen, Ablauf aufweist. Somit wird das Fluid auf kürzestem Weg von dem Aufnahmemittel zum Fluidsammelbecken geleitet und kann von dort aus über den Boden des Fluidsammelbeckens und im Boden vorgesehene Abläufe abgezogen und insbesondere für die Wiederverwendung aufbereitet werden.

Soweit das Aufnahmemittel, insbesondere ausschließlich im Bereich des Umfangsrands, auf dem, insbesondere als, vorzugsweise rotationssymmetrischer, Hohlkörper ausgebildeten, Rotationsmittel fixierbar ist, ist das Aufnahmemittel austauschbar, beispielsweise bei Verschleiß/Verschmutzung oder Abnutzung oder zur Anpassung des Fluidaufnahmevolumens. Durch Fixierung ausschließlich im Bereich des Umfangsrands ist eine materialsparende Ausführung möglich und darüber hinaus ist ein Zugang zum Aufnahmemittel von unten möglich, insbesondere für ein weiter unten beschriebenes Heizmittel.

Indem ein, insbesondere als, vorzugsweise rotationssymmetrischer, Hohlkörper ausgebildeter, Stator zur Halterung des im Stator rotierbaren Rotationsmittels vorgesehen ist, ist eine platzsparende und materialschonende Ausgestaltung der Vorrichtung erfindungsgemäß möglich.

Dabei ist es erfindungsgemäß von Vorteil, wenn die Vorrichtung so ausgebildet ist, dass die Rotation des Rotationsmittels entlang eines, insbesondere ringförmigen, am Innenumfang des Stators angeordneten Führungsabschnitts, insbesondere mittels eines Kugellagers zwischen dem Führungsabschnitt und einem korrespondierenden Führungsabschnitt des Rotationsmittels erfolgt. Diese Ausführung führt zu einer stabilen Ausgestaltung der Vorrichtung, so dass eine entsprechend hohe Rotationsgeschwindigkeit und ein schneller Austrag des Fluids aus dem Aufnahmemittel erfindungsgemäß möglich sind.

Gemäß einer weiteren, erfindungsgemäßen Ausführungsform sind Heizmittel zur Temperatursteuerung des Fluids vorgesehen, insbesondere in Form eines vorzugsweise rotierbaren, Heizkörpers mit einer Heizplatte. Die Heizmittel sind insbesondere unterhalb der Aufnahmemittel und/oder innerhalb des Rotationsmittels anordenbar. Über eine entsprechende Steuerungseinrichtung ist das Heizmittel in seine Betriebsposition verfahrbar und entsprechend ist die Rotierung des Heizmittels steuerbar. Durch Rotation des Heizmittels erfolgt erfindungsgemäß eine Homogenisierung der Temperaturbeaufschlagung entlang des Aufnahmemittels. Hierzu trägt auch eine äquidistante Anordnung der Heizplatte beziehungsweise der dem Aufnahmemittel zugewandten Oberfläche der Heizplatte bei. Die Position der Heizplatte zur Unterseite des, insbesondere wannenförmigen (Wanne), Aufnahmemittels ist vorzugsweise kontrollierbar und einstellbar. Der optimale Abstand zwischen der Unterseite der Wanne (Aufnahmemittel) und der Oberseite der Heizplatte ist dabei kleiner als 1cm, mit Vorzug kleiner als 1mm, mit größerem Vorzug kleiner als 300µm, mit größtem Vorzug kleiner als 100µm, mit allergrößtem Vorzug kleiner als 50µm. Der Raum zwischen der Heizplatte und der Wanne kann erfindungsgemäß auch mit einem Gas gespült werden, welches vorzugsweise gute Wärmekonvektionseigenschaften besitzt, um die Wärme optimal von der Heizplatte zur Wanne zu transportieren. Das Gas kann entweder über Düsen (nicht eingezeichnet), die in den Zwischenraum ragen oder sich in der Heizplatte befinden, eingebracht werden. Da die Heizplatte drehbar gelagert sein kann, ist der Kontakt zwischen der Oberseite der Heizplatte und der Unterseite der Wanne bei einer Relativdrehung beider Bauteile vorzugsweise zu verhindern. Erfolgt keine Relativdrehung zwischen Heizplatte und Wanne, ist eine Kontaktierung der Oberfläche der Heizplatte mit der Unterseite der Wanne zur schnelleren Wärmeübertragung oder zum Vorheizen denkbar. Vorstellbar ist auch, dass die Welle, auf welcher die Heizplatte sitzt, über eine Kupplung (nicht eingezeichnet) mit der Hohlwelle auf der die Wanne liegt, kuppelt und so den später beschriebenen Abschleudervorgang durch die Wannenrotation bewerkstelligt.

Anstelle der Heizplatte ist auch ein Ultraschallkopf denkbar, der mit der Unterseite der Wanne in Kontakt fährt und Schallwellen in die Flüssigkeit der Wanne einkoppelt um beispielsweise Reinigungsvorgänge zu beschleunigen. Eine Kombination aus Ultraschallkopf und Heizplatte ist auch denkbar. Sollte die Einkopplung der Ultraschallwellen in die Flüssigkeit ohne Direktkontakt der Oberfläche des Ultraschallkopfes mit der Unterseite der Wanne über den Gasraum möglich sein, so soll dies hier ebenfalls offenbart sein.

Weiterhin ist erfindungsgemäß vorgesehen, dass die Eintauchmittel, insbesondere rotierbare, Fixiermittel zur Fixierung des Substrats an einer von der Substratbehandlungsfläche abgewandten Aufnahmefläche aufweisen und durch Rotation des Substrats während der Behandlung der Substratbehandlungsfläche, also in einem in Fluid eingetauchten Zustand, wird die meist mit einer chemischen Reaktion verbundene Behandlung deutlich beschleunigt. Die Rotation kann auch intervallweise erfolgen. Weiterhin kann die erfindungsgemäße Rotation des Fixiermittels zum Abschleudern von an dem Substrat anhaftenden Fluid nach der Behandlung, also in einer Position oberhalb des Fluids, verwendet werden. Soweit das Abschleudern kurz oberhalb der Fluidoberfläche erfolgt, wird möglichst wenig Fluid verschwendet, da der überwiegende Teil des Fluids in das Aufnahmemittel tropft beziehungsweise geschleudert wird. Soweit Fluid über den Rand des Aufnahmemittels geschleudert wird, wird es automatisch im Auffangbehälter angesammelt. Indem die Rotationsgeschwindigkeit beim Herausfahren des Substrats aus dem Fluid, insbesondere bis auf Null, reduziert wird und erst anschließend langsam erhöht wird, wird die Rückführung des Fluids in das Aufnahmemittel weiter optimiert.

Gemäß einer weiteren, vorteilhaften Ausführungsform der Erfindung ist vorgesehen, dass die Eintauchmittel Spülmittel zum Bespülen einer außerhalb der Substratbehandlungsfläche und außerhalb der Aufnahmefläche verbleibenden Spülfläche mit einem Spülfluid aufweist. Hierdurch wird vermieden, dass das Fluid zur Behandlung der Substratbehandlungsfläche andere Bereiche als die Substratbehandlungsfläche am Substrat beaufschlagt. Als Spülfluid kommt insbesondere ein Inertgas in Frage, damit eine Durchmischung mit dem Fluid zur Behandlung des Substrats vermieden beziehungsweise verhindert wird. Bei dem Spülfluid kann es sich auch um Flüssigkeiten handeln. Entscheidend ist, dass während des Reinigungsvorganges der Vorderseite des Wafers, die Reinigungssubstanz der Wanne, die Rückseite des Wafers nicht, oder nur in sehr geringen Mengen benetzen kann.

Beim erfindungsgemäßen Verfahren ist gemäß einer vorteilhaften Ausführungsform vorgesehen, dass das Rotationsmittel in einem Stator zur Halterung des Rotationsmittels rotiert wird, wobei die Rotation des Rotationsmittels entlang eines, insbesondere ringförmigen, am Innenumfang des Stators angeordneten Führungsabschnitts, insbesondere mittels eines Kugellagers zwischen dem Führungsabschnitt und einem korrespondierenden Führungsabschnitt des Rotationsmittels, erfolgt.

Verfahrensgemäß kann weiterhin vorgesehen sein, die Temperatur des Fluids durch Heizmittel zur Temperatursteuerung zumindest während des Eintauchens der Substratbehandlungsfläche zu steuern.

Soweit zumindest während des Eintauchens der Substratbehandlungsfläche eine Bespülung einer außerhalb der Substratbehandlungsfläche und einer von der Substratbehandlungsfläche abgewandten Aufnahmefläche verbleibenden Spülfläche erfolgt, wird eine Kontamination oder Beaufschlagung des Substrats außerhalb der Substratbehandlungsfläche vermieden beziehungsweise verhindert.

Verfahrensgemäß ist es weiterhin mit Vorteil vorgesehen, die Substratbehandlungsfläche durch Fixiermittel zur Aufnahme des Substrats zumindest während des Eintauchens zu rotieren. Hierdurch wird die Behandlung beschleunigt.

Die erfindungsgemäße Konstruktion erlaubt auch den Wechsel der Chemikalien in der Wanne zwischen der Verwendung unterschiedlicher Wafer und/oder während der Fixierung eines einzelnen Wafers. Sehr oft soll die Oberfläche eines Wafers, sequentiell mit unterschiedliche Chemikalien behandelt werden. Der Wafer bleibt in einem solchen Verfahren fixiert. Die Wanne wird, insbesondere sequentiell, mit den einzelnen Chemikalien gefüllt. Vor der Verwendung einer neuen Chemikalie wird die alte durch den erfindungsgemäßen Abschleudervorgang aus der Wanne geschleudert. Denkbar ist es auch, die Wanne als Mischbehälter für Chemikalien zu verwenden, um eine entsprechende neue Chemikalie zu erhalten. Zwischen den Verwendungen unterschiedlicher Chemikalien kann es erfindungsgemäß vorgesehen sein, die Wanne mit einem Reinigungsmittel zu säubern. Das Reinigungsmittel gilt in diesem Fall auch als Chemikalie, wird allerdings vorzugsweise nicht mit den Wafer in Verbindung gebracht.

Weitere Vorteile, Merkmale und Einzelheiten der Erfindung ergeben sich aus der nachfolgenden Beschreibung bevorzugter Ausführungsbeispiele sowie anhand der Zeichnungen. Die zeigen in:
- Figur 1: eine schematische Querschnittsansicht einer Ausführungsform der erfindungsgemäßen Vorrichtung und
- Figur 2: eine Explosionsdarstellung der schematischen Ansicht gemäß Figur 1.

In den Figuren sind gleiche Bauteile oder Bauteile mit der gleichen Funktion mit den gleichen Bezugszeichen gekennzeichnet.

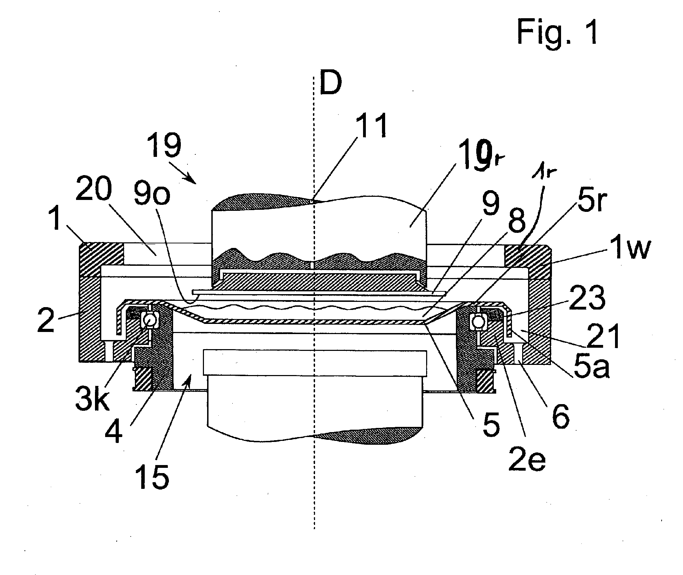

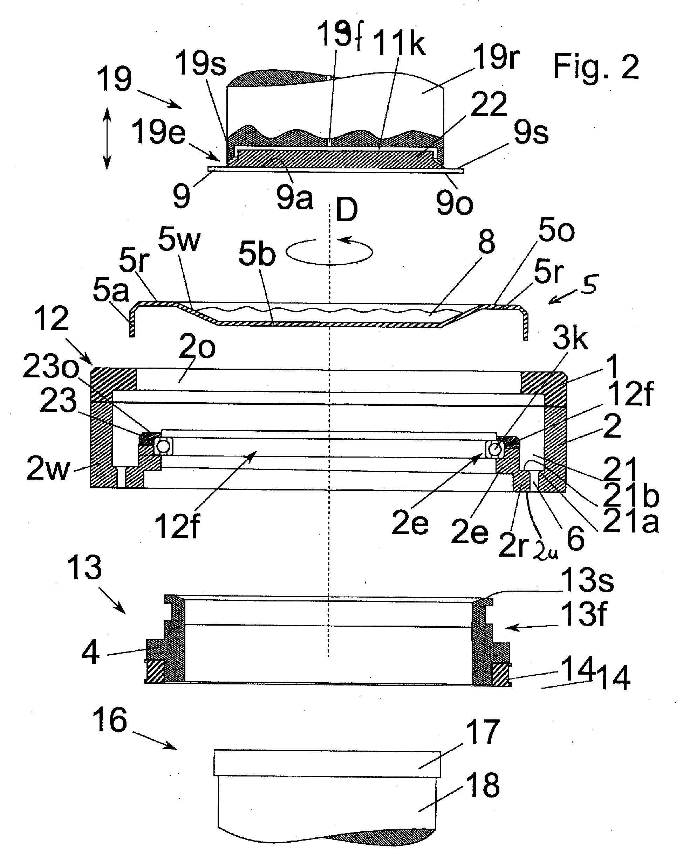

In der in Figuren 1 und 2 gezeigten Ausführungsform der Erfindung besteht die Vorrichtung im Wesentlichen aus fünf Hauptbestandteilen, nämlich einem Stator 12, einem gegenüber dem Stator 12 rotierbaren Rotationsmittel 13 sowie einem auf dem Rotationsmittel 13 fixierbaren Aufnahmemittel 5. Weiterhin ist ein Heizmittel 16 in einen vom Rotationsmittel 13 und dem Aufnahmemittel 5 gebildeten Heizraum 15 ein- und ausfahrbar, und zwar entlang einer Rotationsachse D. Als weiteres, wesentliches Bestandteil ist das Eintauchmittel 19 vorgesehen, das zum Eintauchen eines an Fixiermitteln 22 aufgenommenen Substrats 9 in ein im Aufnahmemittel 5 vorgesehenes Fluid 8 dient. Hierzu ist das Eintauchmittel 19 entlang der Rotationsachse D verfahrbar ausgebildet.

Die Fixiermittel 22 sind im vorliegenden Ausführungsbeispiel Bestandteil der Eintauchmittel 19 und an diesen an einer Eintauchseite 19e an einem durch eine Steuerungseinrichtung rotierbaren Rotationskörper 19r durch Stege 19s angebracht. Zwischen dem Rotationskörper 19r und dem Fixiermittel 22 ist ein Spülfluidkanal 11k von Spülmitteln 11 zum Speisen eines Spülfluids von einer den Rotationskörper 19r durchsetzenden Spülfluidleitung 19f vorgesehen. Als Spülfluid kommt insbesondere Inertgas in Frage, mit welchem das Substrat 9 zumindest teilweise mit Spülfluid beaufschlagbar ist.

Als Fixiermittel 22 ist ein Chuck vorgesehen, der insbesondere über Vakuumbahnen zur Fixierung und Aufnahme des Substrats 9 an einer Aufnahmefläche 9a über nicht dargestellte Vakuumbahnen dient. Die Vakuumbahnen können analog der Spülfluidleitung 19f oder durch die Stege 19s hindurch an eine Vakuumeinrichtung angeschlossen sein. Die Aufnahme des Substrats 9 mit dem Fixiermittel 22 erfolgt in an sich bekannter Weise.

Der Stator 12 besteht aus einem rotationssymmetrischen Unterteil 2 mit einer kreisringförmigen Umfangswand 2w. An einer Unterseite 2u erstreckt sich von der Umfangswand 2w ausgehend ein kreisringförmiger Ringabsatz 2r radial nach innen. Von dem Ringabsatz 2r erstreckt sich parallel zur Umfangswand 2w ein Lagerring 21. Zur Ausbildung eines Führungsabschnitts 12f als Bestandteil eines Kugellagers 3 an dem Lagerring 21 ist ein auf dem Lagerring 21 befestigbarer Lagerdeckel 23 fixierbar.

Ein korrespondierender Führungsabschnitt 13f des Kugellagers 3 ist am Umfang des als Hohlkörper ausgebildeten Rotationsmittels 13 vorgesehen. Die Montage des Rotationsmittels 13 an den Stator 12 erfolgt durch Ausrichtung der Führungsabschnitte 12f und 13f, wobei der Lagerdeckel 23 erst auf dem Lagerring 21 befestigt wird, wenn Kugeln 3k des Kugellagers 3 in dieses eingesetzt sind. Durch Fixierung des Lagerdeckels 23 wird das Kugellager 3 fertiggestellt.

Das Rotationsmittel 13 überragt an einer oberen Stirnseite 13s eine Oberseite 23o des Lagerdeckels 23, damit das auf der Stirnseite 13s mit einem Umfangsrand 5r aufliegende Aufnahmemittel 5 mit Abstand zu dem Lagerdeckel 23 angeordnet ist, obwohl der Umfangsrand 5r eine gerade, radial verlaufende Oberkante 5o aufweist.

Der Umfangsrand 5r verläuft nicht nur über den Lagerdeckel 23, sondern überkragt auch den Lagerring 21 in einem parallel zur Rotationsachse D verlaufenden Ringabschnitt 5a. Der Ringabschnitt 5a verläuft mit Abstand zu dem Lagerring 21 und dem Lagerdeckel 23 und endet in einem Fluidsammelbecken 21. Das Fluidsammelbecken 21 wird durch den Lagerring 21, den Ringabsatz 2r und die Umfangswand 2w gebildet, wobei ein Boden 21b des Fluidsammelbeckens 21 durch den Ringabsatz 2r gebildet wird.

Die Rotationsmittel 13 sind somit durch das Kugellager 3 relativ zu dem fixierten Stator 12 rotierbar, und zwar durch am Rotationsmittel 13 angeordnete Antriebsmittel 14, die von einem, insbesondere am Stator 12 angebrachten, nicht dargestellten Antriebsmotor antreibbar sind, der von einer nicht dargestellten Steuereinrichtung gesteuert wird.

Die Antriebsmittel 14 sind an einem Hohlkörper 4 des Rotationsmittels 13 an einem unteren Abschnitt vorgesehen, während der Führungsabschnitt 13f an einem oberen Abschnitt des Hohlkörpers 4 angeordnet ist. Die Aufnahmemittel 5 sind innerhalb des Umfangsrandes 5r wannenförmig ausgebildet, wobei eine sich an den Umfangsrand 5r anschließende Wannenwand 5w nicht parallel zu der Rotationsachse D, sondern angewinkelt zur Rotationsachse D unter einem Wannenwandwinkel W zwischen 15 Grad und 75 Grad, insbesondere zwischen 30 Grad und 70 Grad, bis zu einem Wannenboden 5b verläuft. Durch die Wannenwand 5w und den Wannenboden 5b wird eine wannenförmige Eintauchöffnung 5e des Aufnahmemittels 5 gebildet.

Das Aufnahmemittel 5 ist über eine nicht dargestellte, insbesondere frei, vorzugsweise gesteuert durch die Steuerungseinrichtung, bewegliche, Fluidleitung mit dem Fluid 8 befüllbar. Das Aufnahmemittel 5 ist so bemessen, dass das Substrat 9 zumindest mit einer gegenüberliegend zur Aufnahmefläche 9a angeordneten Substratbehandlungsfläche 9o in das Fluid 8 eintauchbar ist.

Die Aufnahmefläche 9a ist, insbesondere zumindest überwiegend, durch das Fixiermittel 22 verdeckt und wird dort nicht mit Fluid 8 beaufschlagt.

Spätestens beim Eintauchen des Substrats 9 in das Fluid 8 wird das Spülfluid durch die Spülmittel 11 entlang einer außerhalb der Aufnahmefläche 9a und außerhalb der Substratbehandlungsfläche 9o vorgesehenen Spülfläche 9s gespült. Diese erstreckt sich ringförmig um die Aufnahmefläche 9a und das Spülen mit dem Spülfluid führt dazu, dass (auch) die Spülfläche 9s möglichst nicht mit dem Fluid 8 beaufschlagt wird.

Sobald die Substratbehandlungsfläche 9o in das Fluid 8 eingetaucht ist, wird das Substrat 9 durch Rotation der Eintauchmittel 19 rotiert, so dass die Wirkung des Fluids 8 beschleunigt wird.

Zusätzlich kann die Wirkung des Fluids 8 auf die Substratbehandlungsfläche 9o beschleunigt werden, indem die Heizmittel 16 in den durch die Aufnahmemittel 5 und das Rotationsmittel 13 gebildeten Heizraum 15 eingefahren und aktiviert werden. Die Heizmittel 16 umfassen eine dem Wannenboden 5b zugewandte Heizplatte 17 und einen die Heizplatte aufnehmenden Heizkörper 18, der zur Vergleichmäßigung der Heizwirkung rotierbar ausgebildet ist.

Sobald die Behandlung der Substratbehandlungsfläche 9o abgeschlossen ist, wird die Rotationsgeschwindigkeit der Eintauchmittel 19 verringert und das Substrat 9 aus dem Fluid 8 herausgefahren, und zwar in die in Figur 1 gezeigte Position. In dieser Position wird die Rotation des Substrats 9 wieder beschleunigt, damit etwaiges an dem Substrat 9 anhaftendes Fluid 8 zunächst abtropft und anschließend abgeschleudert wird. Der größte Teil des abtropfenden beziehungsweise abgeschleuderten Fluids 8 wird in dem Aufnahmemittel 5 verbleiben, während ein Bruchteil, vorzugsweise weniger als 10%, über den Umfangsrand 5r hinweggeschleudert und in dem Fluidsammelbecken 21 aufgefangen wird.

Nachdem mindestens ein Substrat 9, vorzugsweise aber mehrere Substrate 9 entsprechend behandelt wurden, wird ein Austausch des Fluids 8 notwendig. Hierzu wird bei ausgefahrenem Eintauchmittel 19 das Rotationsmittel 13 durch die Antriebsmittel 14 angetrieben, wodurch das Fluid 8 mittels der auf das Fluid 8 wirkenden Zentrifugalkraft radial von der Rotationsachse D aus nach außen entlang dem Wannenboden 5b und der Wannenwand 5r über den Umfangsrand 5r bis in das Fluidsammelbecken 21 hinein ausgetragen wird.

Am Boden 21b beziehungsweise an dessen tiefster Stelle, insbesondere in einem abgesenkten Bereich 21a, sind am Umfang des Ringabsatzes 2r mehrere Abläufe 6 verteilt angeordnet, durch die, insbesondere über ein von der Steuereinrichtung ansteuerbares Ventil, das Fluid 8 gezielt abgezogen werden kann und einer Aufbereitung zugeführt werden kann.

Um das Fluid 8 möglichst vollständig in dem Fluidsammelbecken 21 aufzufangen, ist an dem Unterteil 2 ein Oberteil 1 vorgesehen, das eine zur Umfangswand 2w korrespondierende Umfangswand 1w und einen radial nach innen gerichteten Ringabsatz 1r aufweist. Das Oberteil 1 ist dabei so gestaltet, dass aus dem Aufnahmemittel 5 entlang der Wannenwand 5w nach außen geschleudertes Fluid 8 an der von der Umfangswand 1w und dem Ringabsatz 1r gebildeten L-förmigen Innenwand abgefangen wird und von dort in das Fluidsammelbecken 21 tropft oder entlang der Umfangswand 2w in das Fluidsammelbecken 21 läuft.

Der Ringabsatz 1r bildet eine Öffnung 20, durch welche das Eintauchmittel 19 zum Aufnahmemittel 5 bewegbar ist. Das Oberteil 1 ist als separates Bauteil ausgebildet, da die Öffnung 20 einen Öffnungsdurchmesser kleiner als der Durchmesser des Aufnahmemittels an dem Ringabschnitt 5a aufweist.

### Bezugszeichenliste

- 1: Oberteil
- 1w: Umfangswand
- 1r: Ringabsatz
- 2: Unterteil
- 2w: Umfangswand
- 2r: Ringabsatz
- 2l: Lagerring
- 2u: Unterseite
- 3: Lager
- 3k: Kugeln
- 4: Hohlkörper
- 5: Aufnahmemittel
- 5r: Umfangsrand
- 5o: Oberkante
- 5a: Ringabschnitt
- 5b: Wannenboden
- 5e: Eintauchöffnung
- 5w: Wannenwand
- 6: Ablauf
- 8: Fluid
- 9: Substrat
- 9o: Substratbehandlungsfläche
- 9a: Aufnahmefläche
- 9s: Spülfläche
- 11: Spülmittel
- 11k: Spülfluidkanal
- 12: Stator
- 12f: Führungsabschnitt
- 13: Rotationsmittel
- 13f: Führungsabschnitt
- 13s: Stirnseite
- 14: Antriebsmittel
- 15: Heizraum
- 16: Heizmittel
- 17: Heizplatte
- 18: Heizkörper
- 19: Eintauchmittel
- 19e: Eintauchseite
- 19r: Rotationskörper
- 19s: Stege
- 19f: Spülfluidleitung
- 20: Öffnung
- 21: Fluidsammelbecken
- 21a: Abgesenkter Bereich
- 21b: Boden
- 22: Fixiermittel
- 23: Lagerdeckel
- 23o: Oberseite
- D: Rotationsachse
- W: Wannenwandwinkel

## Patentansprüche

1. Vorrichtung zur Behandlung einer Substratbehandlungsfläche (9o) eines Substrats (9) mit einem Fluid (8) durch Eintauchen der Substratbehandlungsfläche (9o) in das Fluid (8), mit folgenden Merkmalen:
- Aufnahmemittel (5) zur Aufnahme des Fluids (8) mit einer Eintauchöffnung (5e) und
- Eintauchmittel (19) zum Eintauchen der Substratbehandlungsflächen (9o) durch die Eintauchöffnung (5e) in das Aufnahmemittel (5),
**dadurch gekennzeichnet, dass** das Eintauchmittel (19) Fixiermittel (22) zur Fixierung des Substrats (9) an einer von der Substratbehandlungsfläche (9o) abgewandten Aufnahmefläche (9a) aufweist und dass Rotationsmittel (13) zur Rotation des Aufnahmemittels (5) zum zumindest überwiegenden Austrag des Fluids (8) aus dem Aufnahmemittel (5) vorgesehen sind.

2. Vorrichtung gemäß Anspruch 1, bei der das Aufnahmemittel (5) als, insbesondere rotationssymmetrische, Wanne, insbesondere mit einer in Radialrichtung angewinkelten Wannenwand (5w) ausgebildet ist.

3. Vorrichtung nach Anspruch 2, bei der die Wanne einen entgegen der Wannenform gekrümmten, insbesondere die Rotationsmittel (13) überkragenden, Umfangsrand (5r) zur Ableitung des Fluids (8) zu einem, insbesondere ringförmigen, Fluidsammelbecken (21) aufweist.

4. Vorrichtung nach Anspruch 3, bei der das, insbesondere durch einen Stator (12) gebildete, Fluidsammelbecken (21) an seinem Boden (21b), insbesondere in mindestens einem abgesenkten Bereich (21a), vorzugsweise an der tiefsten Stelle des Fluidsammelbeckens (21), mindestens einen, insbesondere jeweils mit einem ansteuerbaren Ventil versehenen, Ablauf (6) aufweist.

5. Vorrichtung nach einem der vorhergehenden Ansprüche, bei der das Aufnahmemittel (5), insbesondere ausschließlich im Bereich des Umfangsrands (5r), auf dem, insbesondere als, vorzugsweise rotationssymmetrischer, Hohlkörper (4) ausgebildeten, Rotationsmittel (13) fixierbar ist.

6. Vorrichtung nach einem der Ansprüche 4 oder 5, bei der ein, insbesondere als, vorzugsweise rotationssymmetrischer, Hohlkörper ausgebildeter, Stator (12) zur Halterung des im Stator (12) rotierbaren Rotationsmittels (13) vorgesehen ist.

7. Vorrichtung nach Anspruch 6, wobei die Vorrichtung so ausgebildet ist, dass die Rotation des Rotationsmittels (13) entlang eines, insbesondere ringförmigen, am Innenumfang des Stators (12) angeordneten Führungsabschnitts (12f), insbesondere mittels eines Kugellagers (3) zwischen dem Führungsabschnitt (12f) und einem korrespondierenden Führungsabschnitt (13f) des Rotationsmittels (13) erfolgt.

8. Vorrichtung nach einem oder mehreren der vorhergehenden Ansprüche, bei der Heizmittel (16) zur Temperatursteuerung des Fluids (18) vorgesehen sind, insbesondere in Form eines, vorzugsweise rotierbaren, Heizkörpers (18) mit einer Heizplatte (17).

9. Vorrichtung nach einem oder mehreren der vorgehenden Ansprüche, bei der das Eintauchmittel (19) Spülmittel (11) zum Bespülen einer außerhalb der Substratbehandlungsfläche (9o) und der Aufnahmefläche (9a) verbleibenden Spülfläche (9s) mit einem Spülfluid aufweist.

10. Verfahren zur Behandlung mindestens einer Substratsbehandlungsfläche (9o) eines Substrats (9) mit einem Fluid (8) mit folgenden Schritten, insbesondere folgendem Ablauf:
- Fixierung und Aufnahme des Substrats (9) durch Eintauchmittel (19) an einer von der Substratsbehandlungsfläche (9o) abgewandten Aufnahmefläche (9a),
- Eintauchen der Substratbehandlungsfläche(n) in das in einem Aufnahmemittel (5) zur Aufnahme des Fluids (8) aufgenommene Fluid (8) und
- Rotation des Aufnahmemittels (5) zum Entleeren des Fluids aus dem Aufnahmemittel (5).

11. Verfahren nach Anspruch 10, bei dem ein Rotationsmittel (13) in einem Stator (12) rotierbar gehaltert wird, wobei die Rotation des Rotationsmittels (13) entlang eines, insbesondere ringförmigen, am Innenumfang des Stators (12) angeordneten Führungsabschnitts (12f), insbesondere mittels eines Kugellagers (3) zwischen dem Führungsabschnitt (12f) und einem korrespondierenden Führungsabschnitt (13f) des Rotationsmittels (13) erfolgt.

12. Verfahren nach einem der Ansprüche 10 oder 11, bei dem die Temperatur des Fluids (8) durch Heizmittel (16) zur Temperatursteuerung zumindest während des Eintauchens der Substratbehandlungsfläche (9o) gesteuert wird.

13. Verfahren nach einem oder mehreren der Ansprüche 10 bis 12, bei dem zumindest während des Eintauchens der Substratbehandlungsfläche (9o) eine Bespülung einer außerhalb der Substratbehandlungsfläche (9o) und außerhalb einer von der Substratbehandlungsfläche (9o) abgewandten Aufnahmefläche (9a) verbleibenden Spülfläche (9s) erfolgt.

14. Verfahren nach einem oder mehreren der Ansprüche 10 bis 13, bei dem die Substratbehandlungsfläche (9o) durch Fixiermittel (22) zur Aufnahme des Substrats (9) zumindest während des Eintauchens rotiert wird.

## Claims

1. A device for treatment of a substrate treatment surface (9o) of a substrate (9) with a fluid (8) by immersion of the substrate treatment surface (9o) into the fluid (8), with the following features:
- receiving means (5) for receiving the fluid (8) with an immersion opening (5e) and
- immersion means (19) for immersion of the substrate treatment surfaces (9o) through the immersion opening (5e) into the receiving means (5),
**characterized in that** the immersion means (19) have fixing means (22) for fixing the substrate (9) on one receiving surface (9a) which faces away from the substrate treatment surface (9o) and that rotation means (13) are designated for rotation of the receiving means (5) for at least predominant discharge of the fluid (8) from the receiving means (5).

2. The device as claimed in Claim 1, wherein the receiving means (5) is made as an especially rotationally symmetrical trough, especially with one trough wall (5w) which is angled in the radial direction.

3. The device as claimed in Claim 2, wherein the trough has a peripheral edge (5r) which is curved against the trough shape and which projects especially over the rotation means (13) for discharging the fluid (8) to an especially ring-shaped fluid collection tank (21).

4. The device as claimed in Claim 3, wherein the fluid collection tank (21) which is formed especially by a stator (12) on its bottom (21b), especially in at least one sunken region (21a), preferably at the lowest point of the fluid collection tank (21), has at least one drain (6) which is provided especially with a triggerable valve.

5. The device as claimed in one of the proceeding claims, wherein the receiving means (5), especially solely in the region of the peripheral edge (5r), can be fixed on the rotation means (13) which is made as a, especially symmetrical, preferably rotationally symmetrical, hollow body (4).

6. The device as claimed in one of Claims 4 or 5, wherein there is a stator (12) which is made as a, especially symmetrical, preferably rotationally symmetrical, hollow body for holding the rotation means (13) which can rotate in the stator (12).

7. The device as claimed in Claim 6, wherein the device is made such that the rotation of the rotation means (13) takes place along a, especially ring-shaped, guide segment (12f) which is located on the inner periphery of the stator (12), especially by means of a ball bearing (3) between the guide segment (12f) and a corresponding guide segment (13f) of the rotation means (13).

8. The device as claimed in claim 1 or 2, wherein there are heating means (16) for temperature control of the fluid (18), especially in the form of a, preferably rotatable, heating body (18) with a heating plate (17).

9. The device as claimed in one of the proceeding claims, wherein the immersion means (19) has flushing means (11) for flushing of a flushing surface (9s) which remains outside the substrate treatment surface (9o) and the receiving surface (9a), using a flushing fluid.

10. A method for treatment of at least one substrate treatment surface (9o) of a substrate (9) with a fluid (8) with the following steps, especially following sequence:
- fixing and receiving the substrate (9) by means of immersion means (19) on a receiving surface (9a) which faces away from the substrate treatment surface (9o),
- immersion of the substrate treatment surface(s) into the fluid (8) which is held in a receiving means (5) for receiving the fluid (8) and
- rotation of the receiving means (5) for emptying the fluid out of the receiving means (5).

11. The method as claimed in Claim 10, wherein a rotation means (13) held to be able to rotate in a stator (12), the rotation of rotation means (13) taking place along an especially ring-shaped guide segment (12f) which is located on the inner periphery of the stator (12), especially by means of a ball bearing (3) between the guide segment (12f) and a corresponding guide segment (13f) of the rotation means (13).

12. The method as claimed in one of Claims 10 or 11, wherein the temperature of the fluid (8) is controlled by heating means (16) for temperature control at least during the immersion of the substrate treatment surface (9o).

13. The method as claimed in one or more of Claims 10 to 12, wherein during the immersion of the substrate treatment surface (9o) a flushing of a flushing surface (9s) which remains outside a substrate treatment surface (9o) and outside a receiving surface (9a) which faces away from the substrate treatment surface (9o) takes place.

14. The method as claimed in one or more of Claims 10 to 13, wherein the substrate treatment surface (9o) is rotated by fixing means (22) for receiving the substrate (9) at least during the immersion.

## Revendications

1. Dispositif pour traiter une surface de traitement de substrat (9o) d'un substrat (9) avec un fluide (8) par immersion de la surface de traitement de substrat (9o) dans le fluide (8), présentant les caractéristiques suivantes :
- un moyen de réception (5) pour recevoir le fluide (8), comprenant une ouverture d'immersion (5e) et
- un moyen d'immersion (19) pour immerger les surfaces de traitement de substrat (9o) dans le moyen de réception (5) par l'ouverture d'immersion (5e) ;
**caractérisé en ce que** le moyen d'immersion (19) présente des moyens de fixation (22) pour fixer le substrat (9) sur une surface de réception (9a) éloignée de la surface de traitement de substrat (9o) et que
des moyens de rotation (13) sont prévus pour faire tourner le moyen de réception (5) pour faire sortir au moins la majeure partie du fluide (8) hors du moyen de réception (5).

2. Dispositif selon la revendication 1, dans lequel le moyen de réception (5) est conçu en tant que cuve, en particulier symétrique en rotation, en particulier avec une paroi de cuve (5w) coudée dans le sens radial.

3. Dispositif selon la revendication 2, dans lequel la cuve présente un bord périphérique (5r) courbé contre la forme de la cuve, particulièrement en saillie sur les moyens de rotation (13), pour détourner le fluide (8) vers un bassin de collecte de fluide (21) notamment annulaire.

4. Dispositif selon la revendication 3, dans lequel le bassin de collecte de fluide (21) formé en particulier par un stator (12), présente sur son fond (21b), en particulier dans au moins une partie creusée (21a), de préférence à l'endroit le plus profond du bassin de collecte de fluide (21), au moins une évacuation (6) dotée en particulier d'une valve pouvant être commandée.

5. Dispositif selon l'une des revendications précédentes, dans lequel le moyen de réception (5), en particulier exclusivement au niveau du bord périphérique (5r), peut être fixé sur le moyen de rotation (13) conçu en particulier en tant que corps creux (4) symétrique en rotation de préférence.

6. Dispositif selon l'une des revendications 4 ou 5, dans lequel un stator (12) conçu en particulier en tant que corps creux, symétrique en rotation de préférence, est prévu pour maintenir le moyen de rotation (13) rotatif dans le stator (12).

7. Dispositif selon la revendication 6, dans lequel le dispositif est ainsi conçu que la rotation du moyen de rotation (13) s'effectue le long d'un tronçon de guidage (12f) en particulier annulaire, disposé sur le périmètre intérieur du stator (12), en particulier au moyen d'un palier à billes (3) entre le tronçon de guidage (12f) et un tronçon de guidage (13f) correspondant du moyen de rotation (13).

8. Dispositif selon l'une ou plusieurs des revendications précédentes, dans lequel des moyens de chauffage (16) sont prévus pour la commande de température du fluide (18), en particulier sous forme d'un corps de chauffage (18) avec une plaque de chauffage (17).

9. Dispositif selon l'une ou plusieurs des revendications précédentes, dans lequel le moyen d'immersion (19) présente des moyens de rinçage (11) pour rincer avec un fluide de rinçage une surface de rinçage (9s) restant en-dehors de la surface de traitement de substrat (9o) et de la surface de réception (9a).

10. Procédé de traitement d'au moins une surface de traitement de substrat (9o) d'un substrat (9) avec un fluide (8) comprenant les étapes suivantes, en particulier le déroulement suivant :
- fixation et réception du substrat (9) par des moyens d'immersion (19) sur une surface de réception (9a) éloignée de la surface de traitement de substrat (9o),
- immersion de la/des surface(s) de traitement de substrat (9o) dans le fluide (8) contenu dans un moyen de réception (5) pour recevoir le fluide (8), et
- rotation du moyen de réception (5) de manière à vider le moyen de réception (5) du fluide contenu.

11. Procédé selon la revendication 10, dans lequel un moyen de rotation (13) peut être maintenu en rotation dans un stator (12), sachant que la rotation du moyen de rotation (13) s'effectue le long d'un tronçon de guidage (12f) en particulier annulaire, disposé sur le périmètre intérieur du stator (12), en particulier au moyen d'un palier à billes (3) entre le tronçon de guidage (12f) et un tronçon de guidage (13f) correspondant du moyen de rotation (13).

12. Procédé selon l'une des revendications 10 ou 11, dans lequel la température du fluide (8) est commandée par des moyens de chauffage (16) pour commander la température au moins pendant l'immersion de la surface de traitement de substrat (9o).

13. Procédé selon l'une des revendications 10 à 12, dans lequel, au moins pendant l'immersion de la surface de traitement de substrat (9o), un rinçage est effectué d'une surface de rinçage (9s) restant en-dehors de la surface de traitement de substrat (9o) et en-dehors d'une surface de réception (9a) éloignée de la surface de traitement de substrat (9o).

14. Procédé selon l'une ou plusieurs des revendications 10 à 13, dans lequel la surface de traitement de substrat (9o) est tournée au moins pendant l'immersion, par des moyens de fixation (22), pour recevoir le substrat (9).
